# EUROPEAN PATENT APPLICATION

(11) **EP 3 764 533 A1**
(43) Date of publication of application: **13.01.2021**
(21) Application number: 19764383.6
(22) Date of filing: 18.01.2019
(51) Int. Cl.: H02M 7/48

(54) **INVERTER DEVICE AND METHOD FOR DRIVING SAME**

(30) Priority: 08.03.2018 JP 2018041630
(71) Applicant: Hitachi, Ltd., Tokyo 100-8280 (JP)
(72) Inventor: MIYOSHI, Tomoyuki, Tokyo 100-8280 (JP); SHIRAISHI, Masaki, Tokyo 100-8280 (JP); MORI, Mutsuhiro, Tokyo 100-8280 (JP); NAKATA, Kiyoshi, Tokyo 100-8280 (JP); ISHIKAWA, Katsumi, Tokyo 100-8280 (JP); KOUNO, Yasuhiko, Tokyo 100-8280 (JP); HOTTA, Yusuke, Tokyo 100-8280 (JP)
(74) Representative: MERH-IP Matias Erny Reichl Hoffmann Patentanwälte PartG mbB
(86) International application number: PCT/JP2019/001524
(87) International publication number: WO 2019/171783

(57) **Abstract**

The purpose of the present invention is to provide a PWM-controlled inverter device that has less power loss than a PWM-controlled inverter device using a single gate IGBT and outputs an AC wave having small ripple and low noise. The inverter device is configured such that first and second dual gate IGBTs are used for the upper and lower arms of each of the three phases and diodes are connected in reverse parallel therewith. A first gate terminal of the first dual gate IGBT is driven by a first gate signal which is generated using a first PWM signal obtained by modulating a conduction width on the basis of a voltage command signal. A second gate terminal is driven by a second gate signal generated using a third PWM signal which is modulated to have a conduction width shorter than the conduction width of the first PWM signal on the basis of the first PWM signal, and which is positioned within the period of the conduction width of the first PWM signal. First and second gate signals for the second dual gate IGBT are similarly generated from a second PWM signal obtained by reversing the positive or negative phase of the first PWM signal.

## Description

### TECHNICAL FIELD

The present invention relates to an inverter device and can be suitably applied, particularly, to an inverter device for driving a motor used for a railway car and the like by PWM (Pulse Width Modulation) control.

### BACKGROUND ART

Along with the worldwide trend toward energy saving and global environmental conservation, power conversion devices are being applied to motor drive sources for various products to use AC motors. Such applications have been spreading into fields of, for example, electric railway cars and wind power generation systems requiring large motor capacities. Concerning motor drive systems for electric railway cars, in particular, to achieve high system efficiency, efficiency improvement is being promoted for motors and converters for driving motors.

Generally, to drive an AC motor at variable speed, an inverter is used as a power conversion device for converting a DC voltage into a desired frequency and voltage, and the voltage and frequency applied to the AC motor is controlled by PWM-controlling a semiconductor switching device included in the inverter.

In a general circuit configuration of an existing type of inverter device, for example, as illustrated in Patent Literature 1 (Fig. 1), IGBTs which are semiconductor switching devices having upper and lower arms are connected to a three-phase inductive load configuring an AC motor. In the IGBTs operating as an inverter, power loss referred to as conduction loss and switching loss occurs.

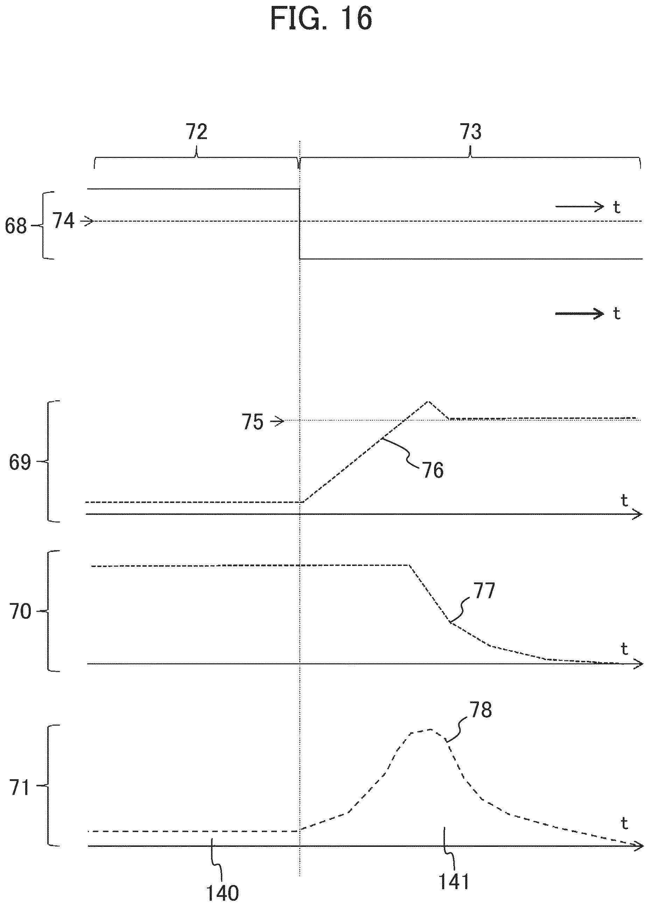

Fig. 16 is a diagram showing a gate signal 68, a collector-emitter voltage waveform 69, a collector current waveform 70, and a current-voltage product 71 based on the two waveforms respectively in each of a conducting state 72 and a not-conducting state 73 of an IGBT. When an on signal is applied to a gate causing the IGBT to conduct, a current flows through the IGBT and an on voltage is applied across the collector and the emitter. This represents a voltage drop caused by a resistance attributable to carriers inside the IGBT, and the product 78 of the on voltage and the current generates a power loss 140. Next, when an off signal is applied to the gate, carriers inside the IGBT are discharged causing the collector-emitter voltage to rise. When the voltage applied to the inverter reaches a voltage 75, discharging of carriers stops and the current decreases. When this shifting from an on state to an off state occurs, the current-voltage product 78 rises and a power loss 141 called a turn-off loss occurs. Furthermore, when an on signal is applied to the gate in an off state, the current-voltage product increases on the same principle and causes a power loss called a turn-off loss to occur. The sum of the turn-off loss and the turn-on loss is a switching loss.

In the inverter, the conduction loss and the switching loss of each IGBT cause the device to generate heat. Therefore, so as to suppress a resultant temperature rise, measures are taken to meet a temperature standard and obtain desired performance by limiting the current to flow through each IGBT and increasing the number of parallel connections. Thus, by decreasing the power loss per device and raising the allowable current rating, per-volume conversion efficiency can be improved and, as the number of parallel-connected devices decreases, effects such as reduction of volume occupied by devices and a cost reduction can be achieved.

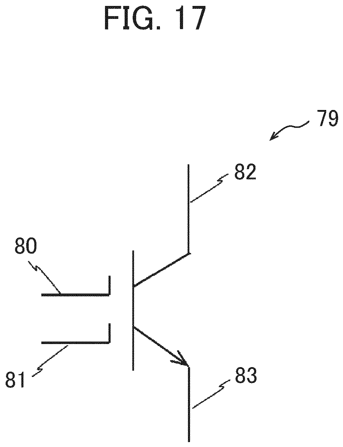

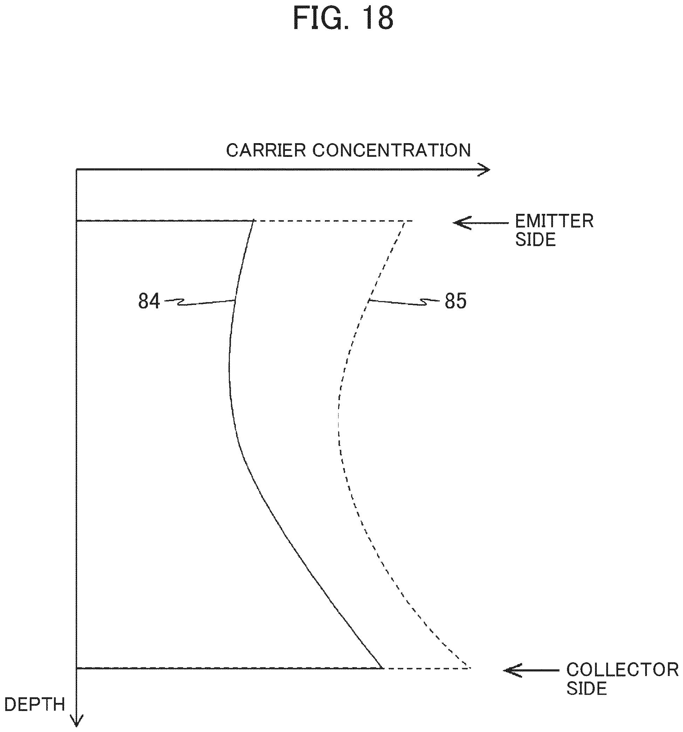

Also, as technology for reducing power loss in an IGBT, a dual gate IGBT having two gate terminals is described in Patent Literature 2 and 3. Fig. 17 is a symbol diagram of a dual gate IGBT 79. The dual gate IGBT has a collector terminal 82, an emitter terminal 83 and two gate terminals 80 and 81, and conduction/non-conduction of the dual gate IGBT is controlled using gate signals inputted to the two gate terminals. Fig. 18 is a diagram showing carrier concentration profiles of a dual gate IGBT in conducting states. Carrier concentrations in two cases are shown; in a case 85, an on signal is given to two gates and, in a case 84, an on signal is given to one gate and an off signal is given to the other gate. In the case 85 in which an on signal is given to the two gates, hole carrier injection through the emitter is promoted to increase carrier concentration in the IGBT. This decreases the on voltage applied to make the IGBT conduct. On the other hand, in the case 84 in which an on signal is given to one gate and an off signal is given to the other gate, hole carriers are discharged through the emitter, thereby decreasing the internal carrier concentration. Namely, when a dual gate IGBT is made to conduct, carrier concentration can be modulated using an additional gate and the gate voltage applied thereto. This feature makes it possible, by turning one gate signal off for an IGBT immediately before turning the IGBT off, to reduce the carrier concentration in the IGBT immediately before the IGBT is turned off and realize a low turn-off loss characteristic.

### CITATION LIST

### Patent Literature

Patent literature 1: WO Publication: 2012/165196
Patent literature 2: Japanese Unexamined Patent Application Publication No. 2005-191221
Patent literature 3: WO Publication No. 2014-038064

### SUMMARY OF INVENTION

### Technical Problem

The present inventors have come to acquire the following findings as a result of earnestly studying applications of dual gate IGBTs to PWM-controlled inverters for motor driving.

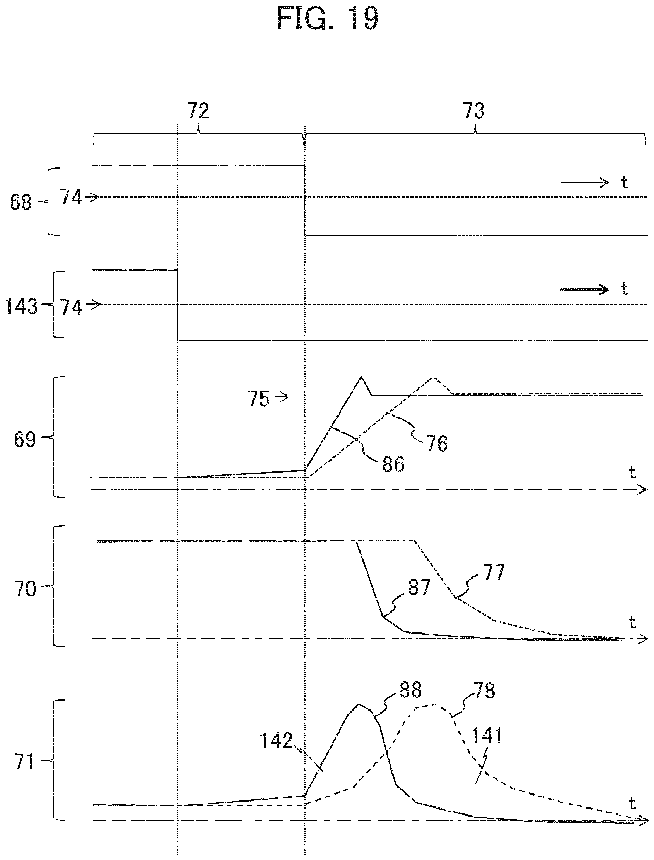

The present invention realizes a low-loss effect by applying two gate signals at appropriate timing to the two gates of a dual gate IGBT. Fig. 19 is a diagram showing two gate signals 68 and 143, collector-emitter voltage waveforms 69, collector current waveforms 70, and current-voltage products 71 based on the waveforms respectively in each of a conducting state 72 and a not-conducting state 73 of a dual gate IGBT. Of the collector-emitter voltage waveforms 69, collector current waveforms 70 and current-voltage products 71 shown in Fig. 19, those in solid lines represent characteristics of a dual gate IGBT and those in broken lines represent characteristics of an existing type of single gate IGBT. The dual gate IGBT is driven in a manner in which, immediately before an off signal is inputted to the switching gate 68 in an on state 72, an off signal is inputted to the other carrier control gate 143. Turning off of the carrier control gate 143 reduces the carrier concentration in the IGBT and causes the on voltage to rise temporarily. Subsequently, when the switching gate 68 turns off, the IGBT shifts from a conductive state to a non-conductive state. As the IGBT in a state of low carrier concentration shifts to a non-conductive state, the depletion process in the IGBT is promoted causing the collector-emitter voltage 69 to rise quickly (waveform 86) compared to existing cases. Furthermore, since carriers are also discharged at high speed, the current 70 reduces to 0 A in a short period of time (waveform 87). This follows that the turn-off loss 142 derived by time integration of the current-voltage product 71 is largely reduced compared to the turn-off loss 141 in the case of an existing type of single gate IGBT. This characteristic makes the dual gate IGBT and the driving method therefor technology effective for loss reduction and efficiency improvement for power conversion functions.

On the other hand, to apply dual gate IGBTs to PWM-controlled inverter devices for motor driving, however, it has been essential to adopt an upper/lower arm drive system which can realize low-loss performance by maintaining quality and operational reliability of an AC output waveform and to optimize a circuit for generating two drive signals and arrangement of the circuit.

An object of the present invention is to provide an inverter device using dual gate IGBTs to configure upper and lower arms of each inverter phase and realizing low power loss compared to existing types of PWM-controlled inverter devices using IGBTs. Solution to Problem

To achieve the above object, the inverter device according to the present invention uses dual gate IGBTs as semiconductor switching devices with each dual gate IGBT having a first gate terminal and a second gate terminal and shifting from a non-conductive state to a conductive state when a voltage equal to or higher than a threshold voltage is applied to at least one of the gate terminals and from a conductive state to a non-conductive state when a voltage lower than the threshold voltage is applied to the first and second gate terminals. The inverter device includes: a first dual gate IGBT connected to an upper arm of each of three phases and a second dual gate IGBT connected to a lower arm of each of the three phases; and a diode connected in reverse parallel to each of the first and second dual gate IGBTs. The first gate terminal of the first dual gate IGBT is driven by a first gate signal generated by using a first PWM signal having a conduction width modulated based on a voltage command signal for load drive control. The second gate terminal of the first dual gate IGBT is driven by a second gate signal generated by using a third PWM signal which has a conduction width modulated based on the first PWM signal to be shorter than the conduction width of the first PWM signal and which is positioned within a period of the conduction width of the first PWM signal. The first gate terminal of the second dual gate IGBT is driven by a third gate signal generated by using a second PWM signal with a polarity inverted with respect to the first PWM signal. The second gate terminal of the second dual gate IGBT is driven by a fourth gate signal generated by using a fourth PWM signal which has a conduction width modulated based on the second PWM signal to be shorter than the conduction width of the second PWM signal and which is positioned within a period of the conduction width of the second PWM signal.

### Advantageous Effects of Invention

According to the present invention, an inverter device for motor driving is provided, which features both low loss and high quality achieved by generating effects of reducing turn-off switching loss and turn-on switching loss occurring when IGBTs make switching.

### BRIEF DESCRIPTION OF DRAWINGS

Fig. 1 is a circuit diagram of an inverter device according to a first embodiment of the present invention.
Fig. 2 is a diagram showing control signals for realizing inverter operations according to the first embodiment.
Fig. 3 is a diagram showing turn-off and turn-on switching waveforms of a dual gate IGBT.
Fig. 4 is a diagram showing inverter losses in an existing type of an inverter device and in an inverter device according to the present invention.
Fig. 5 is a diagram showing input signals and output waveforms of an inverter device applied with the present invention and an inverter device without the present invention applied.
Fig. 6 is a circuit diagram of an inverter device according to a second embodiment of the present invention.
Fig. 7 is a diagram showing control signals for realizing inverter operations according to the second embodiment.
Fig. 8 is a flowchart of a sequence for determining control signals for a dual gate IGBT according to the second embodiment.
Fig. 9 is a diagram showing command signals for normal width operation and for narrow-width operation.
Fig. 10 is a circuit diagram of an inverter device according to a third embodiment of the present invention.
Fig. 11 is a diagram showing a feedback signal and a failure detection signal according to the third embodiment along with gate control signals.
Fig. 12 is a circuit diagram of an inverter device according to a fourth embodiment of the present invention.
Fig. 13 is a diagram showing feedback signals and a failure detection signal (at a time of erroneous turning on of Gs) according to the fourth embodiment along with gate control signals.
Fig. 14 is a diagram showing feedback signals and a failure detection signal (at a time of erroneous turning on of Gc) according to the fourth embodiment along with gate control signals.
Fig. 15 is a circuit diagram of an inverter device according to a fifth embodiment of the present invention.
Fig. 16 is a diagram showing a gate signal, a collector-emitter voltage, a collector current, and a current-voltage product respectively in each of an IGBT conducting state and an IGBT not-conducting state.
Fig. 17 is a symbol diagram of a dual gate IGBT.
Fig. 18 is a diagram showing carrier concentration profiles of a dual gate IGBT in conducting states.
Fig. 19 is a diagram showing two gate signals, collector-emitter voltages, collector currents, and current-voltage products respectively in each of an IGBT conducting state and an IGBT not-conducting state.

### DESCRIPTION OF EMBODIMENTS

In the following, first through fifth embodiments of the present invention will be described with reference to drawings.

### First Embodiment

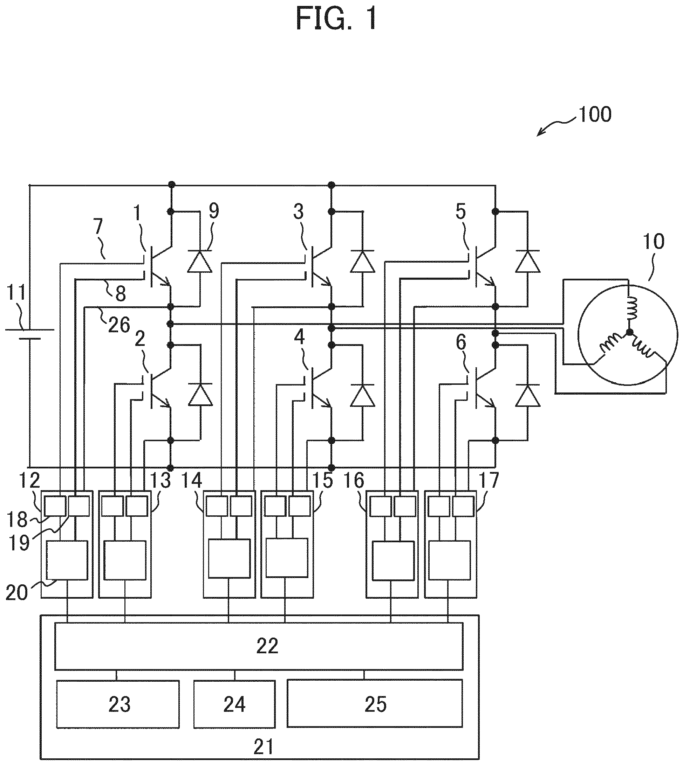

Fig. 1 is a circuit diagram of an inverter device 100 according to a first embodiment of the present invention.

The first embodiment concerns an inverter device applied with dual gate IGBTs each having two independently controllable gates. A three-phase inductive load 10 configuring an AC motor (may hereinafter be referred to also as a "motor 10") is connected with dual gate IGBTs 1 to 6 which are semiconductor switching devices configuring upper and lower arms. The dual gate IGBTs 1 to 6 are each connected in reverse parallel with a diode 9.

The dual gate IGBTs 1 to 6 each include two insulated gate terminals 7 and 8 (hereinafter referred to simply as "gate terminals") and an emitter terminal 26 and each control conduction and non-conduction using a gate-emitter voltage (hereinafter referred to as a "gate voltage") applied to the two gate terminals. Namely, when a gate voltage equal to or higher than a threshold is applied to at least one of the two gate terminals of an IGBT, the IGBT conducts and, when the voltage applied to the two gate terminals is lower than the threshold voltage, the IGBT does not conduct.

The inverter device 100 is supplied with DC power from a voltage source 11 and supplies AC power to an inductive load 10 by having the IGBTs 1 to 6 repeatedly turn on and off at high speed using the gate voltage applied to the gate terminals 7 and 8 of the IGBTs 1 to 6. This provides the AC motor with a rotatory power.

The gate voltages of the dual gate IGBT 1 is generated by gate drive circuits 12 to 17 connected to the IGBTs 1 to 6 configuring three-phase upper and lower arms. In this configuration, two each gate terminals 7 and 8 of the dual gate IGBTs as well as two each gate lines leading from each gate drive circuit 12 to the corresponding two each gate terminals 7 and 8 are mutually electrically insulated, and are each controlled independently by the corresponding gate drive circuit 12. Each emitter terminal 26 is also connected to the corresponding gate drive circuit 12 and is fixed at an internal reference potential.

The gate drive circuits are each configured with, taking the gate drive circuit 12 as an example, a PWM signal conversion unit 20 which generate signals to drive the gates 7 and 8 of the dual gate IGBT 1 and two output buffers 18 and 19. The two output buffers 18 and 19 include switching devices (not shown) which adjust two PWM signals generated at the PWM signal conversion circuit 20 to voltages capable of turning the gates 7 and 8 of the IGBT 1 on and off. The PWM signal conversion units 20 have a function to receive PWM signals for the three-phase upper and lower arms, each also functioning to convert the received PWM signal into two PWM signals having a time difference between them and also to convert the received PWM signal into an insulated signal.

The PWM signals to be inputted to the gate drive circuit 12 are generated by a PWM control calculation unit 22 included in a PWM inverter control unit 21 which is positioned on a substrate electrically isolated from the gate drive circuit 12. The PWM control calculation unit 22 includes a comparator and a calculation device (not shown) which generate PWM signals with modulated conduction widths based on three-phase voltage command signals (modulated waves) for driving the motor 10, carrier waves, and signals from the vector control calculation unit 25. Also, the vector control calculation unit 25 included in the PWM inverter control unit 21 performs calculations for reducing the deviation between the value of current outputted from the IGBT that is detected by a current sensor (not shown) provided in an output line of the inverter and a set value, and transmits control signals for realizing high-quality AC output signals of the inverter to the PWM control calculation unit 22.

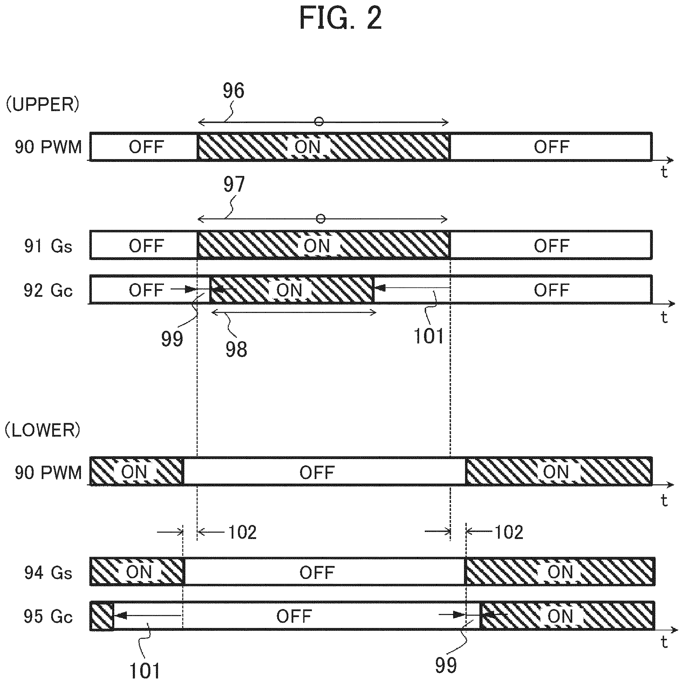

Fig. 2 is a diagram showing control signals for realizing inverter operations according to the present first embodiment. The signals shown in Fig. 2 are PWM signals 90 and 93 for controlling the dual gate IGBTs positioned in the upper and lower arms of one of the three phases of the inverter, two upper-arm gate signals 91 and 92 and two lower-arm gate signals 94 and 95, the gate signals being gate drive signals generated based on the respective PWM signals. The PWM signals and gate drive signals for commanding the dual gate IGBTs positioned in the upper and lower arms of the other two phases are shifted 120° (not shown) from the corresponding signals shown in Fig. 2.

The signals generated by the PWM control calculation unit 22 for the upper and lower arms turn on and off at mutually opposite phases and include non-lapping periods 102, during which the upper and lower arms both stay off prior to on/off switching operation, so as to prevent the dual gate IGBTs from getting short-circuited as a result of simultaneous on-signal introduction into the upper and lower arms. Each non-lapping period 102 is desirably in the range of 2 µs to 20 µs.

Now, of the two dual gates of each IGBT, one is defined as a switching gate (Gs) and the other a carrier control gate (Gc). The Gs signal 91 is driven with conduction and no-conduction widths the same as those of the PWM signal 90. The dual gate IGBT performs switching operation by conducting and not conducting based on the timing of the Gs signal 91. The Gc signal 92, on the other hand, shifts from an off state to an on state following elapse of a certain delay time 99 after shifting of the Gs signal 91 from an off state to an on state. This control causes the dual gate IGBT to turn on with low transconductance, so that change dvce/dt of the collector-emitter voltage (Vce) is prevented from getting sharp. This achieves an effect of reducing noise at the time of turning on.

On the other hand, the Gs signal 91 is to be given an on-to-off signal when its conduction width that is the same as that of the PWM signal 90 ends to thereby cause the dual gate IGBT to turn off. Immediately before this occurs, that is, before the Gs signal 91 turns off, an off command is issued for the Gc signal 92. Thus, in this control, the off command issued for the Gc signal 92 causes the carrier concentration in the dual gate IGBT to lower immediately before the dual gate IGBT turns off. Therefore, the dual gate IGBT can turn off at higher speed with a smaller tale current. This reduces the power loss caused when the dual gate IGBT turns off. Furthermore, when making the dual gate IGBT conduct, on commands are inputted to the gates for both the Gs signal 91 and the Gc signal 92, causing the carrier concentration in the IGBT to rise and the conduction loss to reduce. In this control, delay time 99 between the Gs signal and the Gc signal at the time of turning on is desirably 1 µs or over and the delay time 101 between the Gc signal and the Gs signal at the time of turning off is desirably 5 µs or over.

The dual gate IGBT of the other arm and the dual gate IGBTs of the other phases also receive, based on the input PWM signals, the Gs and Gc signals at the same timing and with the same conduction widths as described above. The two signals, Gs signal 91 and Gc signal 92, and their delay times 99 and 101 with respect to the PWM signal 90 are derived by the PWM signal conversion circuit 20 included in the gate drive circuit 12 provided for the upper and lower arms of the three phases.

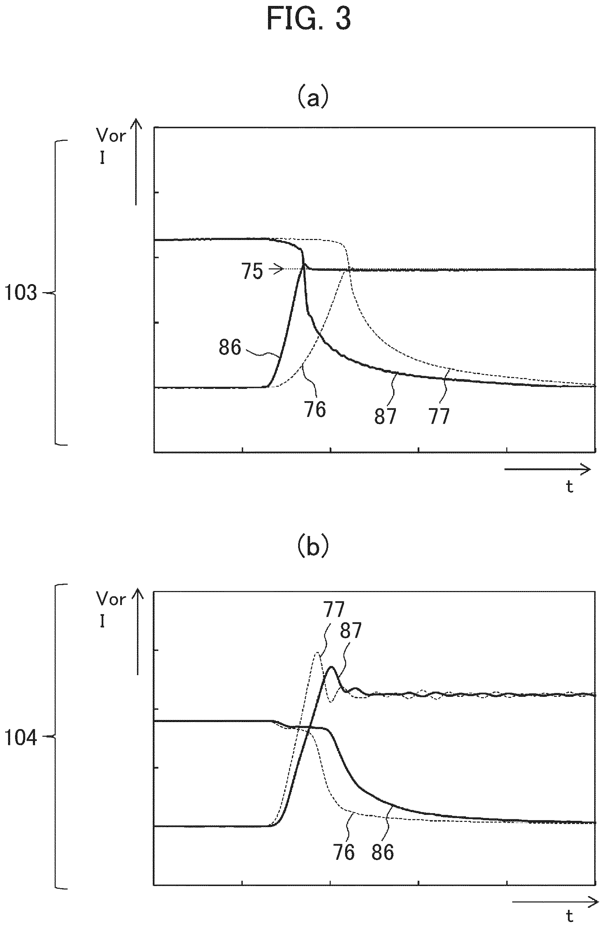

Next, with reference to Figs. 3 to 5, effects of the present first embodiment will be described. Fig. 3(a) shows voltage and current waveforms 103 at the time of turn-off switching of a dual gate IGBT, and Fig. 3(b) shows voltage and current waveforms 104 at the time of turn-on switching of the dual gate IGBT. In the figures, solid lines represent characteristics of the dual gate IGBT and broken lines represent characteristics of an existing type of single gate IGBT, with 76 and 86 denoting voltage waveforms and with 77 and 87 denoting current waveforms.

For turn-off switching (Fig. 3(a)), in the dual gate IGBT, a command to turn off Gc before Gs is applied immediately before switching and, thereby, the carrier concentration is lowered. This causes dvce/dt to rise relative to that in existing cases and Vce to rapidly rise to supply voltage 75 (voltage waveform 86). Subsequently, the current rapidly lowers to 0 A to reduce the tail period of the current (current waveform 87). This characteristic causes the power loss dependent on the product of current and voltage to be smaller in the dual gate IGBT than in the existing type of single gate IGBT (voltage waveform 76 and current waveform 77) and, thus, achieves an effect of reducing the turn-off loss.

On the other hand, at the time of turn-on switching (Fig. 3(b)), the IGBT is caused to turn on by an on signal to the gate on one side, i.e. Gs on signal, and, therefore, the transconductance of the IGBT at the instant of the switching lowers and the rise dic/dt of the collector current (Ic) lowers (current waveform 87). At this time, the diode connected in reverse parallel to the dual gate IGBT of the other arm enters a recovery state in which shifting from a conduction state to a reverse blocking state occurs. The low dic/dt characteristic of the dual gate IGBT suppresses current jumping caused by the recovery current of the diode in the other arm. As a result, the turn-on loss reduces and the noise caused by the current is suppressed and reduces. As described above, application of dual gate IGBTs achieves an effect of reducing loss and noise.

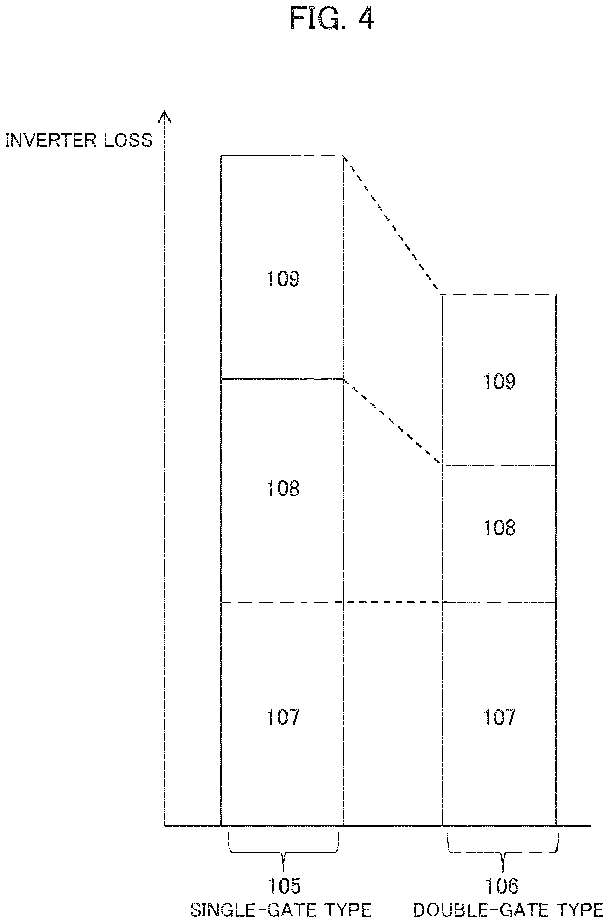

Fig. 4 is a diagram comparing an inverter loss 105 (left bar) of an inverter device using an existing type of single gate IGBTs and an inverter loss 106 (right bar) of an inverter device using dual gate IGBTs according to the present invention. In Fig. 4, breakdowns of power loss occurring in IGBT devices used in inverter devices are shown. The power loss caused by inverter operation in an IGBT is broken down into a conduction loss 107, a turn-off switching loss 108 and a turn-on switching loss 109. Of these losses, the turn-off switching loss 108 and the turn-on switching loss 109 make up the switching loss occurring when an IGBT shifts from a conducting state to a not-conducting state.

As shown, by adopting dual gate IGBTs, a low conduction loss 107 unique to IGBTs can be maintained, and the turn-off switching loss108 and the turn-on switching loss 109 can be respectively reduced. The rates of such reductions of the respective switching losses are about 30% and 10%. This achieves an effect of reducing the power loss occurring in IGBTs used in an inverter device by tens of percent.

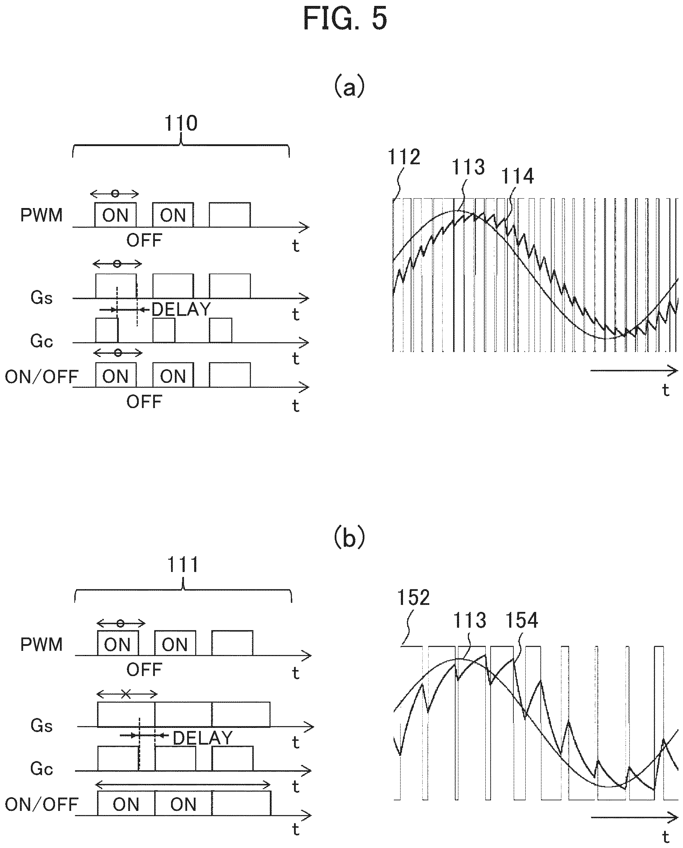

In Fig. 5, Fig. 5(a) shows input signals 110 for an inverter device using dual gate IGBTs according to the present invention and an output current waveform 114 of a phase of the inverter device, and Fig. 5(b) shows input signals 111 for an inverter device using dual gate IGBTs without the present invention applied to and an output current waveform 154 of a phase of the inverter device. According to the present example, in the inverter device using dual gate IGBTs without the present invention applied to, the Gs signal is longer in conduction width than the PWM signal.

In the inverter device according to the present invention, the Gs signal and the PWM signal have a same conduction width (Fig. 5(a)) and the sine waveform of the output current 114 shows smaller pulsation (rippling) compared with when the inverter device without the present invention applied to is used, indicating that the AC waveform quality is higher. This is an effect achieved by controlling such that the conduction and non-conduction widths of the dual gate IGBT agree with the PWM signal on/off commands.

In the inverter device without the present invention applied to, on the other hand, the conduction width of the Gs signal is longer than the PWM signal on command. Therefore, where the gap between a PWM on command and a next PWM on command is small, a Gs signal and a next Gs signal become continuous without any gap between them. This lengthens the conducting time of the IGBT with respect the commands (Fig. 5(b)). This control makes the conduction time virtually longer with respect to the commands. Therefore, rippling of the output current 154 becomes larger to result in lower modulation wave reproducibility and poorer AC waveform quality.

Hence, according to the present invention, by equalizing the on command width in the PWM command and the width of the Gs signal, an effect of realizing a high quality AC output waveform can be obtained.

### Second Embodiment

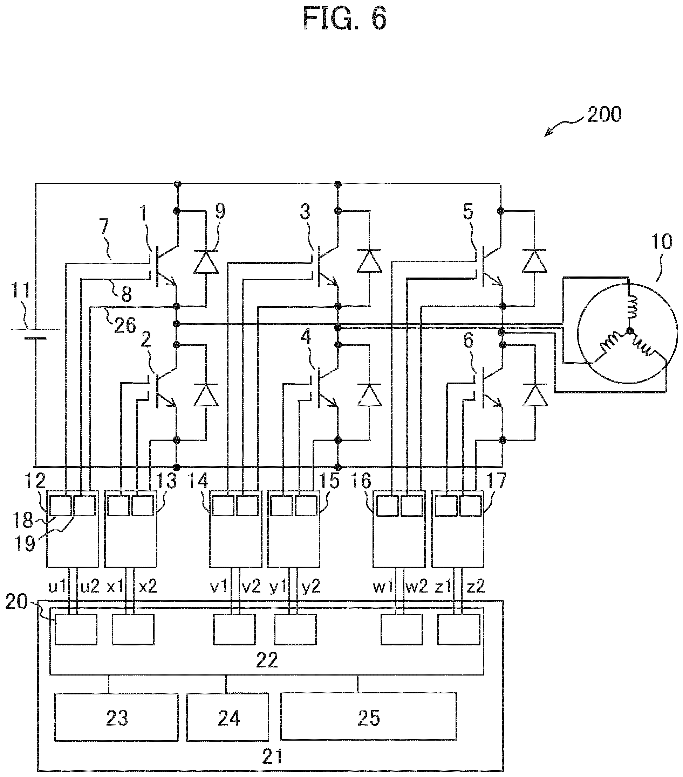

Fig. 6 is a circuit diagram of an inverter device 200 according to a second embodiment of the present invention. The present second embodiment like the foregoing first embodiment also concerns an inverter device applied with dual gate IGBTs each having two independently controllable gates. In the circuit configuration, constituent elements similar to those used in the first embodiment are same-numbered as in the first embodiment. The present second embodiment differs from the first embodiment regarding the internal configurations of the gate drive circuits 12 to 17 and the PWM control calculation unit 22. As for the other constituent elements, the present second embodiment is identical to the first embodiment, so that description will be omitted.

Further, the two PWM signals are also generated, like in the first embodiment, by the PWM control calculation unit 22 included in the PWM inverter control unit 21 that is positioned on a substrate electrically isolated from the gate drive circuits 12 to 17. The PWM control calculation unit 22 outputs, based on optimum command signals generated based on signals received from a carrier frequency calculation unit 23, a modulation wave calculation unit 24 and the vector control calculation unit 25, two PWM signals which determine timing of conduction/non-conduction for dual gate IGBTs 1 to 6 included in the upper and lower arms of three phases to gate drive circuits 12 to 17. Unlike in the first embodiment, the PWM signal conversion units 20 of the present second embodiment are, without being positioned on the substrate including the gate drive circuits 12 to 17, included in the PWM control calculation unit 22 and each generate two PWM signals for commanding driving of the corresponding dual gate IGBT.

The gate drive circuits 12 to 17 each receive two PWM signals for corresponding phase and arm. Taking the gate drive circuit 12 as an example, the two PWM signals are converted into insulated signals and then undergo voltage conversion at the output buffers 18 and 19, respectively. The PWM control calculation unit 22 is configured in a PWM inverter control device 21 positioned on a substrate electrically isolated from the gate drive circuit 12. In the configuration of the present second embodiment, the gate drive circuits 12 to 17 require no PWM signal conversion unit, so that, compared with the first embodiment, the inverter device can be made compacter.

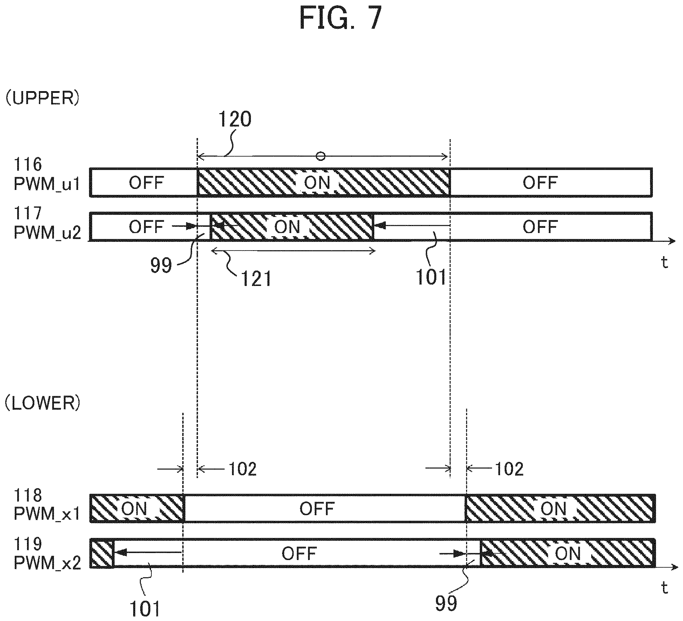

Fig. 7 shows control signals for realizing inverter operations according to the present second embodiment. The signals shown in Fig. 7 are, as control signals for commanding the dual gate IGBTs included in the upper and lower arms of one of the three phases of the inverter, two signals, PWM_u1 116 and PWM_u2 117, and two signals, PWM_x1 118 and PWM_x2 119. The command signals and gate drive signals for the dual gate IGBTs positioned in the upper and lower arms of the other two phases are shifted 120° from the corresponding signals shown in Fig. 7.

Furthermore, of the two types of gates of the dual gate IGBTs, the switching gates (Gs) operate by receiving command signals u1, x1, v1, y1, w1 and z1 and the carrier control gates (Gc) operate by receiving command signals u2, x2, v2, y2, w2, and z2. The conduction time of each IGBT is determined by the on time of Gs. Of the PWM signals, command signals u1, x1, v1, y1, w1, and z1 are signals calculated by the carrier frequency calculation unit 23, modulation wave calculation unit 24 and vector control calculation unit 25 to realize sine waves of AC output of the inverter.

Command signals u2, x2, v2, y2, w2, and z2 on the other hand have a shorter on-width than the on-width of commands u1, x1, v1, y1, w1, and z1. Also, u2, x2, v2, y2, w2, and z2 receive on commands after u1, x1, v1, y1, w1, and z1 have received on-commands, and receive off-commands before u1, x1, v1, y1, w1, and z1 receive off-commands.

The signals used in the upper and lower arms turn on and off at mutually opposite phases and include non-lapping periods 102 during which the upper and lower arms both stay off prior to switching operation so as to prevent the dual gate IGBTs from getting short-circuited as a result of simultaneous on-signal introduction into the upper and lower arms. The non-lapping periods 102 are provided between u1 and x1, v1 and y1, and w1 and z1. Each non-lapping period 102 is desirably in the range of 2 µs to 20 µs.

Switching between conduction and non-conduction of the dual gate IGBTs is controlled by timing of u1, x1, v1, y1, w1, and z1 each applied as a gate voltage at Gs via a gate drive circuit. Turning on of the dual gate IGBTs follows a sequence in which gates Gs change from an off state to an on state responding to PWM commands of u1, x1, v1, y1, w1, and z1, respectively, then, after a certain amount of delay time, the dual gate IGBTs change from an off state to an on state responding to PWM commands of u2, x2, v2, y2, w2, and z2, respectively. This control causes each dual gate IGBT to turn on with low transconductance, so that change dvce/dt of the collector-emitter voltage (Vce) is prevented from getting sharp. This achieves, as in the first embodiment, an effect of reducing noise at the time of turning on.

On the other hand, turning off of the dual gate IGBTs follows a sequence in which, immediately before gates Gs change from an on state to an off state responding to PWM commands of u1, x1, v1, y1, w1, and z1, respectively, gates Gc change from an on state to an off state responding to PWM commands of u2, x2, v2, y2, w2, and z2, respectively. In this control, immediately before each dual gate IGBT turns off, a Gc off signal causes the carrier concentration in the dual gate IGBT to lower. Therefore, the dual gate IGBT can turn off at higher speed with a smaller tale current. This achieves, as in the first embodiment, an effect of reducing the power loss at the time of turning off.

Furthermore, while each dual gate IGBT is conducting, on signals are inputted to both gates, Gs and Gc. This increases the carrier concentration in the IGBT and achieves an effect of reducing the conduction loss. In this control, the delay time between the Gs signal and the Gc signal at the time of turning on is desirably 1 µs or over and the delay time between the Gc signal and the Gs signal at the time of turning off is desirably 5 µs or over. The PWM commands of u1, x1, v1, y1, w1, and z1 and also of u2, x2, v2, y2, w2, and z2 are set to secure the above delay times. Two PWM commands with the above delay times are generated at each PWM signal conversion unit 20 included in the PWM control calculation unit 22.

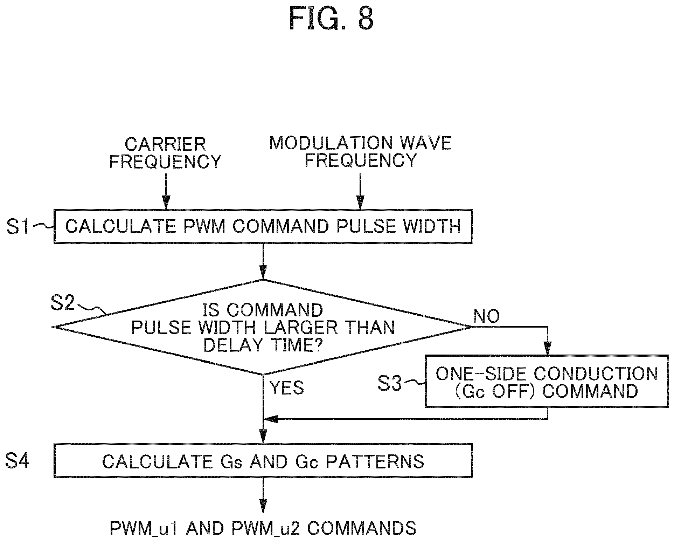

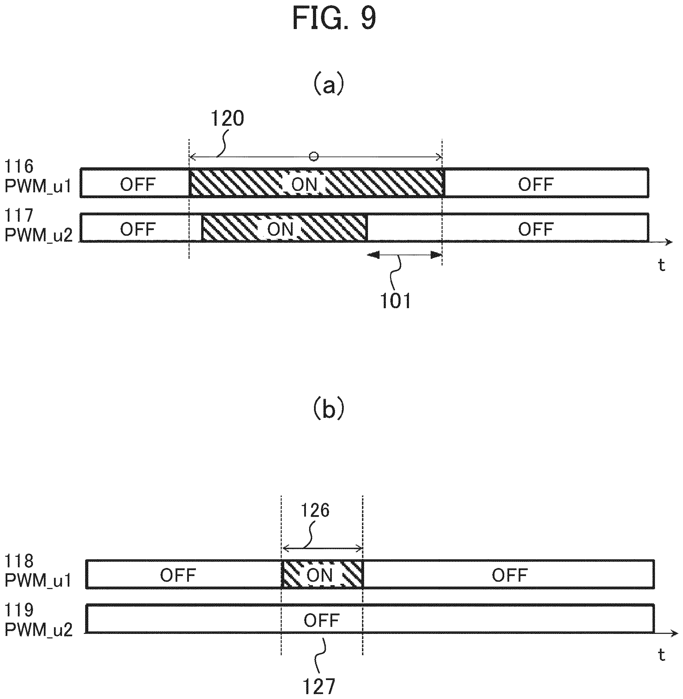

Next, with reference to Figs. 8 and 9, effects achieved, in addition to the effects described with respect to the foregoing first embodiment, by the present second embodiment will be described.

The two PWM signals that determine operation timing of two gate signals for each dual gate IGBT are generated by a programmable integrated circuit (for example, a gate array) included in the PWM control calculation unit 22, and the two PWM signals can be generated in different patterns according to command pulse widths. Fig. 8 is a flowchart of a sequence in which the two gate signals (Gs and Gc) for each dual gate IGBT of the present second embodiment are determined. In PWM control, it is necessary to operate each IGBT using input signals having various on-command widths with modulated conduction widths. According to the present second embodiment, each dual gate IGBT can be operated normally even when on command widths are shorter than the delay times set for the two gate signals (narrow-width commands).

The PWM control calculation unit 22 calculates, in step S1, a PWM command pulse width based on a carrier frequency and a modulation wave frequency. In step S2, whether the calculated command pulse width is larger than a delay time is determined.

When the result of determination is "no," that is, in the case of a narrow-width command, a one-side conduction (Gc off) command is set to keep the Gc signal off, and processing advances to the next step S4. This makes it possible to perform, even in narrow-width operation, conduction/non-conduction control for the dual gate IGBT.

On the other hand, when the result of determination is "yes," an on command with a normal width which is longer than the delay time is set for step S4.

The PWM control calculation unit 22 calculates, in step S4, patterns of the two gate signals (Gs and Gc) including a delay as described above based on the command set in step S2 or step S3 and outputs command signals of, for example, u1 and u2.

Using the above sequence, an effect of reducing the inverter loss as described above can be achieved.

Fig. 9 shows command signals 116 to 119 of u1 and u2 used in normal-width operation and narrow-width operation. Fig. 9(a) represents signals used in normal-width operation and Fig. 9(b) represents signals used in narrow width operation.

In normal-width operation, two command signals u1 and u2 including delay times as shown in Fig. 9(a) drive the dual gate IGBT. On the other hand, in narrow-width operation, as shown in Fig. 9(b), u2 stays in an off state and a command having an on-off pattern is outputted for u1 only. As described above, two command signals can be optimally varied according to the on command widths calculated by the carrier frequency calculation unit 23, modulation wave calculation unit 24 and vector control calculation unit 25.

### Third Embodiment

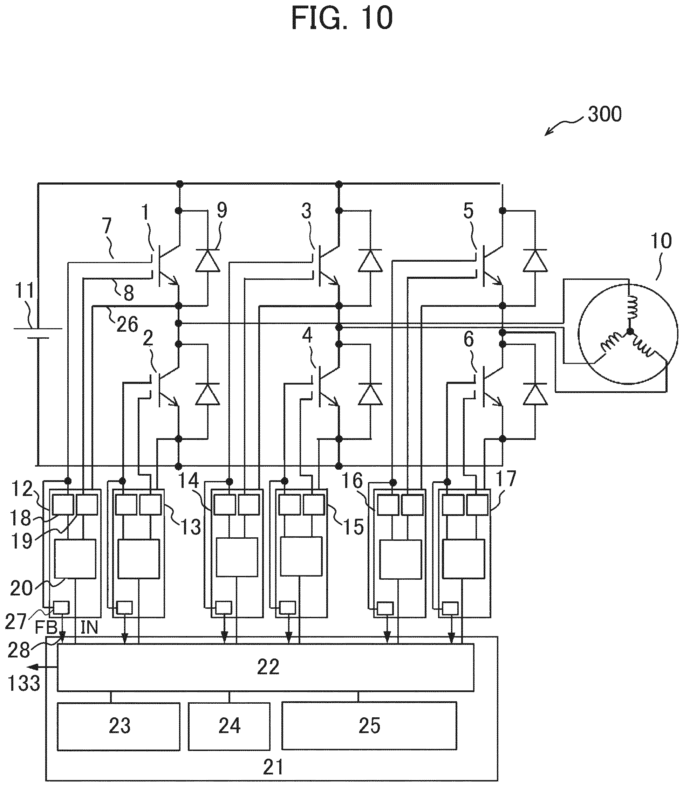

Fig. 10 is a circuit diagram of an inverter device 300 according to a third embodiment of the present invention.

The present third embodiment like the foregoing first and second embodiments also concerns an inverter device applied with dual gate IGBTs each having two independently controllable gates. In the circuit configuration, constituent elements similar to those used in the first embodiment are same-numbered as in the first embodiment. The present third embodiment differs from the first embodiment in that a function of operation failure detection is provided in the gate drive circuits 12 to 17 and PWM control calculation unit 22. As for the other constituent elements, the present third embodiment is identical to the first embodiment, so that description will be omitted.

The present third embodiment includes, additionally to the circuit configuration of the first embodiment, a configuration for operation failure detection being described in the following. The additional configuration is included in each of dual gate IGBTs 1 to 6 of three-phase upper and lower arms, and the following description is based on dual gate IGBT 1 as an example. A feedback signal line 28 is additionally provided which is used to transfer signals sent from a switching gate (Gs) terminal 7 controlling the timing of conduction/non-conduction of the dual gate IGBT 1 and received via a signal line by a level conversion unit 27 included in the gate drive circuit 12 to the PWM control calculation unit 22 included in the PWM inverter control device 21. The feedback signal line 28 senses operation signals at Gs terminal 7 by detecting terminal voltage at Gs terminal 7 of the dual gate IGBT 1 and sends information on Gs on/off operations as feedback signals to the PWM control calculation unit 22. The PWM control calculation unit 22 including a programmable integrated circuit (for example, a gate array) has a function of issuing an alarm or blocking an on command and issuing an off command, when it is determined as a result of comparing PWM commands and feedback signals that the feedback signals do not agree with the PWM commands.

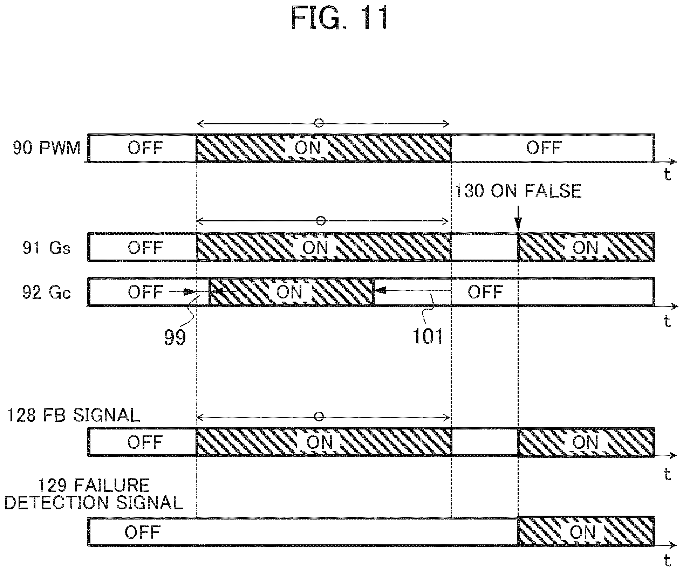

Next, effects achieved, in addition to the effects described with respect to the foregoing first embodiment, by the present third embodiment will be described. Fig. 11 shows a feedback signal (FB) and a failure detection signal according to the present third embodiment along with gate control signals.

Information on the timing of on/off operations matching the controlled Gs signal is sent as feedback signals through the feedback signal line 28, so that the PWM control calculation unit 22 can compare PWM commands with the feedback signals and determine whether the feedback signals agree with the PWM commands. Hence, when the dual gate IGBT operates without following PWM commands, the PWM control calculation unit 22 can issue, for example, a warning signal.

For example, as shown in Fig. 11, when the dual gate IGBT while being given an off command by a PWM signal 90 conducts by performing, for any reason, an erroneous on operation 130 via its own Gs terminal, the PWM control calculation unit 22 can detect the failure by comparing the feedback signal (FB) received and the PWM command 90. This function enables the PWM command to be correctly set again based on a failure detection signal 129, so that a breakdown of the dual gate IGBT device possibly caused by short-circuiting of the upper and lower arms resulting from the erroneous on operation can be prevented. For example, the PWM control calculation unit 22 re-sets the PWM commands for the Gs and Gc signals for the dual gate IGBT in which an operation failure has been detected and for the other dual gate IGBT as non-conduction commands, the two dual gate IGBTs being paired and configuring the upper and lower arms.

Furthermore, the feedback (FB) signal 128 of the present third embodiment can also be used as an information source effective for failure detection in the inverter device.

It has been described that, according to the present third embodiment, a signal line leading from the Gs terminal 7 and a feedback signal line 28 are provided additionally to the circuit configuration of the first embodiment, but these signal lines may also be added to the circuit configuration of the second embodiment.

### Fourth Embodiment

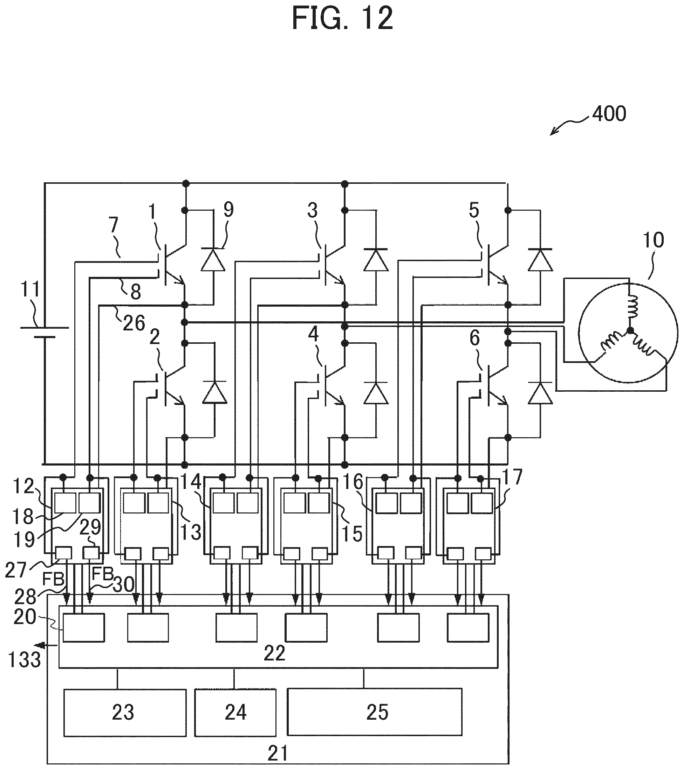

Fig. 12 is a circuit diagram of an inverter device 400 according to a fourth embodiment of the present invention.

The present fourth embodiment like the foregoing first to third embodiments also concerns an inverter device applied with dual gate IGBTs each having two independently controllable gates. The circuit configuration of the present fourth embodiment is based on the circuit configuration of the second embodiment. Namely, unlike the first embodiment, the PWM signal conversion units 20 are not positioned on a substrate including the gate drive circuits 12 to 17, but are included in the PWM control calculation unit 22. Also, like in the third embodiment, signal lines are provided for detecting terminal voltages at switching gate (Gs) terminals 7 controlling the timing of conduction/non-conduction of the dual gate IGBTs 1 to 6 included in three-phase upper and lower arms. Furthermore, signal lines for detecting terminal voltages at carrier control gate (Gc) terminals 8 are also additionally provided (the following description is based on dual gate IGBT 1 as an example).

To be specific, level conversion units 27 and 29 are included in the gate drive circuit 12 and are connected with feedback signal lines 28 and 30, respectively, for feeding signals back to the PWM control calculation unit 22 included in the PWM inverter control device 21. The feedback signal lines 28 and 30 detect terminal voltages at the Gs terminal 7 and Gc terminal 8 of the dual gate IGBT 1 and send out on-off operation information as feedback signals identical to Gs and Gc signals. Also, the PWM control calculation unit 22 including a programmable integrated circuit (for example, a gate array) has a function of issuing an alarm or blocking an on command and issuing an off command, when it is determined that feedback signals do not agree with PWM commands.

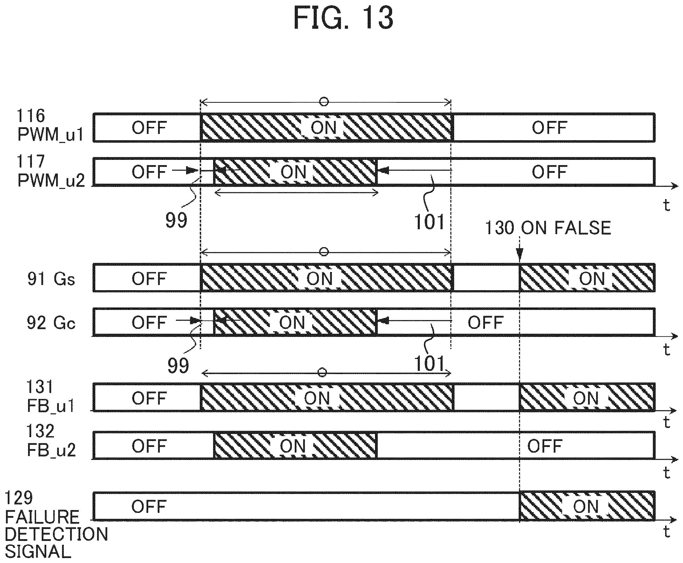

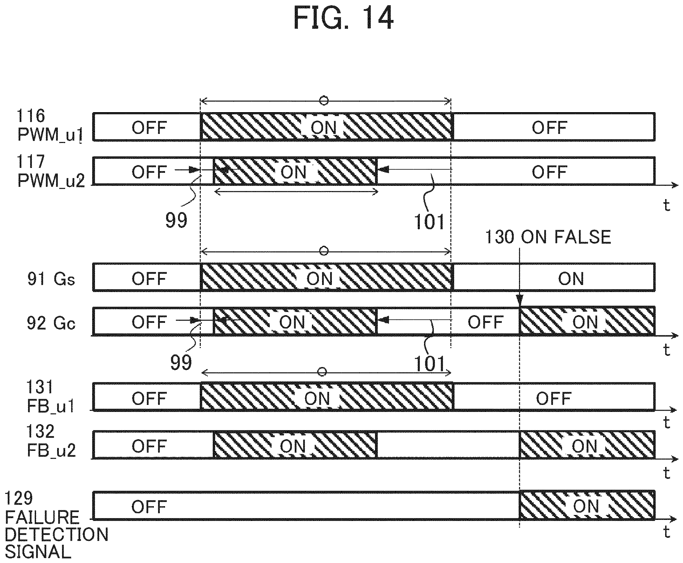

Next, effects achieved, in addition to the effects described with respect to the second embodiment, by the present fourth embodiment will be described. Figs. 13 and 14 each show feedback signals (FB) and a failure detection signal according to the present fourth embodiment along with gate control signals.

Information on the timing of on/off operations matching Gs signals is sent as feedback signals through the feedback signal line 28, so that the PWM control calculation unit 22 can determine whether the feedback signals (representing conduction/non-conduction operations of the IGBT) agree with PWM commands. Similarly, information on the timing of on/off operations matching Gc signals is sent as feedback signals through the feedback signal line 30, so that the PWM control calculation unit 22 can determine whether the feedback signals (representing Gc signal operations) agree with PWM commands. Hence, when the Gs and Gc signals for the dual gate IGBT operate without following PWM commands, the PWM control calculation unit 22 can issue a warning signal.

For example, as shown in Fig. 13, when the dual gate IGBT while being given an off command as a Gs signal 91 by a PWM_u1 signal 116 conducts by performing, for any reason, an erroneous on operation 130 via its own Gs terminal, the PWM control calculation unit 22 can detect the failure by comparing a feedback signal FB_u1 signal 131 received via the feedback signal line 28 and the PWM command (PWM_u1 signal 116).

Also, for example, as shown in Fig. 14, when the dual gate IGBT while being given an off command as a Gc signal 92 by a PWM_u2 signal 117 conducts by performing, for any reason, an erroneous on operation 130 via its own Gc terminal, the PWM control calculation unit 22 can detect the failure by comparing a feedback signal FB_u2 signal 132 received via the feedback signal line 30 and the PWM command (PWM_u2 signal 117).

This function enables a PWM command to be correctly set again based on a failure detection signal 129, so that a breakdown of the dual gate IGBT device possibly caused by short-circuiting of the upper and lower arms resulting from an erroneous on operation attributable to the Gs signal or Gc signal can be prevented. For example, the PWM control calculation unit 22 re-sets the PWM commands for the Gs and Gc signals for the dual gate IGBT in which an operation failure has been detected and for the other dual gate IGBT as non-conduction commands, the two dual gate IGBTs being paired and configuring the upper and lower arms.

Furthermore, the feedback signals of the present fourth embodiment can also be used as an information source effective for failure detection in the inverter device.

It has been described that, according to the present fourth embodiment, signal lines leading from the Gs terminal 7 and Gc terminal 8 and also feedback signal lines 28 and 29 are provided additionally to the circuit configuration of the second embodiment, but these signal lines may also be added to the circuit configuration of the first embodiment.

### Fifth Embodiment

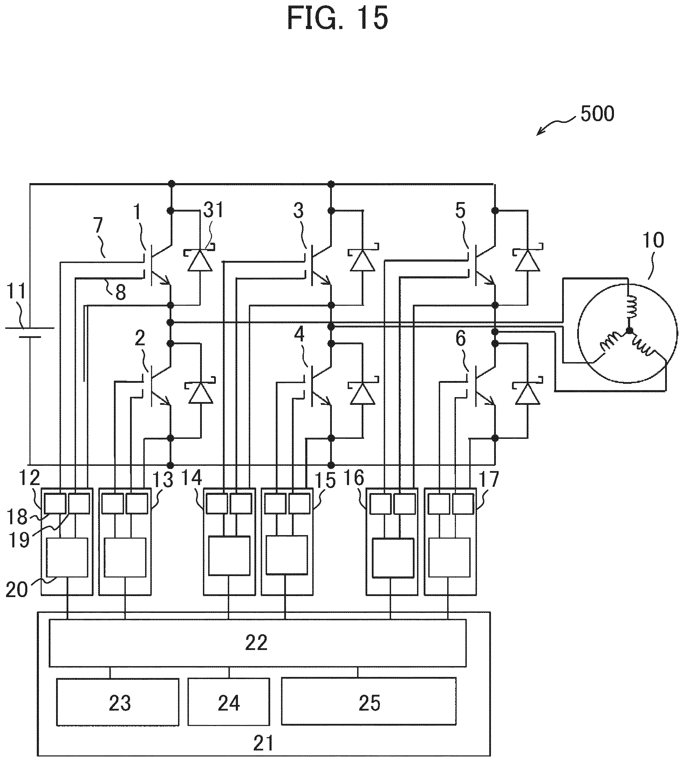

Fig. 15 is a circuit diagram of an inverter device 500 according to a fifth embodiment of the present invention.

The present fifth embodiment like the foregoing first to fourth embodiments also concerns an inverter device applied with dual gate IGBTs each having two independently controllable gates, but differs from the foregoing first to fourth embodiments in that Schottky barrier diodes (SiC-SBD) formed on a semiconductor substrate of SiC (silicon carbide) are used as diodes connected with IGBTs in reverse parallel.

The circuit configuration shown in Fig. 15 will not be described below, since it is the same as the circuit configuration of the foregoing first embodiment except for the use, as described above, of Schottky barrier diodes and both circuits operate in the same manner. Also, the circuit configuration of the present fifth embodiment is not limited to the circuit configuration of the first embodiment and may be replaced by any one of the circuit configurations of the foregoing second to fourth embodiments.

Next, effects achieved, in addition to the effects described with respect to the foregoing first to fourth embodiments, by the present fifth embodiment will be described. The power loss in the inverter device caused by inverter operation is broken down into the conduction loss, turn-off switching loss and turn-on switching loss occurring in the IGBTs as described above and also the recovery loss and conduction loss in the diodes connected in reverse parallel. When an IGBT included in an arm opposite to a diode turns on, the diode shifts from a state of conduction in a forward direction to a reverse blocking state, causing a reverse direction current called a recovery current to temporarily flow.

The recovery loss is a power loss occurring as a product of current and voltage, the current being a recovery current and the voltage being a reverse voltage applied. The recovery voltage depends on carriers in the diode in a conducting state. In the case of a p-n diode with carriers including holes and electrons, it takes time before the carriers having contributed to conductivity modulation disappear, so that the recovery current grows large. In the case of a Schottky diode with carriers including electrons only or holes only, it is characteristic that, when the diode enters a reverse blocking state, the carriers instantly disappear resulting in a small recovery current. Particularly, SiC-SBDs formed on a semiconductor substrate of SiC performs with high withstand voltage.

Therefore, the present fifth embodiment concerning the inverter device 500 in which Sic-SBDs 31 and the dual gate IGBT 1 are combined can reduce, in addition to the turn-off loss and the turn-on loss, the recovery loss and, therefore, can provide an inverter device with further reduced loss.

As described above based on the foregoing first to fifth embodiments, by applying the present invention, an inverter device capable of generating an AC output with low power loss and low-noise can be provided. The invention also makes it possible to maintain high-quality AC sine waves which can be operated with short pulses and, furthermore, to realize high reliability by detecting operation failures to secure safety.

### LIST OF REFERENCE SIGNS

1 ··· U-phase upper arm dual gate IGBT, 2 ··· U-phase lower arm dual gate IGBT, 3 ··· V-phase upper arm dual gate IGBT, 4 ··· V-phase lower arm dual gate IGBT, 5 ··· W-phase upper arm dual gate IGBT, 6 ··· W-phase lower arm dual gate IGBT, 7 ··· Switching gate (Gx) , 8 ··· Carrier control gate (Gc) , 9 ··· Diode, 10 ··· Three-phase inductive load (motor), 11 ··· Source voltage, 12 ··· U-phase upper-arm gate drive circuit, 13 ··· U-phase lower-arm gate drive circuit, 14 ··· V-phase upper-arm gate drive circuit, 15 ··· V-phase lower-arm gate drive circuit, 16 ··· W-phase upper-arm gate drive circuit, 17 ··· W-phase lower-arm gate drive circuit, 18 ··· Output buffer for Gs driving, 19 ··· Output buffer for Gc driving, 20 ··· PWM signal conversion unit, 21 ··· PWM inverter control unit, 22 ··· PWM control calculation unit, 23 ··· Carrier frequency calculation unit, 24 ··· Modulation wave calculation unit, 25 ··· Vector control calculation unit, 26 ··· Emitter terminal, 27 ··· Gs level conversion unit, 28 ··· Gs feedback signal line, 29 ··· Gc level conversion unit, 30 ··· Gc feedback signal line, 31 ··· SiC Schottky barrier diode (SiC-SBD), 40 ··· Diode, 41 ··· U-phase upper-arm IGBT (existing single gate type), 42 ··· U-phase lower-arm IGBT (existing single gate type), 43 ··· V-phase upper-arm IGBT (existing single gate type), 44 ··· V-phase lower-arm IGBT (existing single gate type), 45 ··· W-phase upper-arm IGBT (existing single gate type), 46 ··· W-phase lower-arm IGBT (existing single gate type), 47 ··· Gate, 48 ··· U-phase upper-arm gate drive circuit, 49 ··· U-phase lower-arm gate drive circuit, 50 ··· V-phase upper-arm gate drive circuit, 51 ··· V-phase lower-arm gate drive circuit, 52 ··· W-phase upper-arm gate drive circuit, 53 ··· W-phase lower-arm gate drive circuit, 54 ··· PWM circuit, 55 ··· Current sensor, 56 ··· Modulation wave (sine wave of desired output frequency), 57 ··· Carrier frequency (triangle wave signal), 58 ··· PWM waveform, 59 ··· U-phase gate signal, 60 ··· V-phase gate signal, 61 ··· W-phase gate signal, 62 ··· U-V line voltage, 63 ··· V-W line voltage, 64 ··· W-U line voltage, 65 ··· U-phase current, 66 ··· V-phase current, 67 ··· W-phase current, 68 ··· Gate signal, 69 ··· Voltage, 70 ··· Current, 71 ··· Current-voltage product, 72 ··· Conducting, 73 ··· Not conducting, 74 ··· IGBT threshold voltage, 75 ··· Source voltage, 76 ··· Collector-emitter voltage of existing type of IGBT, 77 ··· Collector current of existing type of IGBT, 78 ··· Current-voltage product of existing type of IGBT, 79 ··· Dual gate IGBT, 80 ··· First gate terminal, 81 ··· Second gate terminal, 82 ··· Collector terminal, 83 ··· Emitter terminal, 84 ··· Carrier concentration distribution with on signal applied to first gate and off signal applied to second gate, 85 ··· Carrier concentration distribution with on signal applied to first and second gates, 86 ··· Collector-emitter voltage of dual gate IGBT, 87 ··· Collector current of dual gate IGBT, 88 ··· Current-voltage product of dual gate IGBT, 90 ··· Upper-arm PWM signal, 91 ··· Upper-arm Gs signal, 92 ··· Upper-arm Gc signal, 93 ··· Lower-arm PWM signal, 94 ··· Lower-arm Gs signal, 95 ··· Lower-arm Gc signal, 96 ··· Conduction command period of PWM signal, 97 ··· Conduction command period of Gs signal, 98 ··· Conduction command period of Gc signal, 99 ··· Turn-on delay period, 100 ··· Inverter device of first embodiment, 101 ··· Turn-off delay period, 102 ··· Non-lapping period, 103 ··· Voltage and current waveforms at turn-off switching, 104 ··· Voltage and current waveforms at turn-on switching, ··· 105 ··· Inverter device applied with single gate IGBT (existing type), 106 ··· Inverter device applied with dual gate IGBT (of present invention), 107 ··· Conduction loss, 108 ··· Turn-off switching loss, 109 ··· Turn-on switching loss, 110 ··· PWM signal, Gs signal, Gc signal and conduction/non-conduction periods applied with present invention, 111 ··· PWM signal, Gs signal, Gc signal and conduction/non-conduction periods not applied with present invention, 112 ··· Gs signal applied with present invention, 113 ··· Modulation wave (target waveform of inverter), 114 ··· Output current waveform applied with present invention, 116 ··· Upper-arm PWM_u1 signal, 117 ··· Upper-arm PWM_u2 signal, 118 ··· Lower-arm PWM_x1 signal, 119 ··· Lower-arm PWM_x2 signal, 120 ··· Conduction command period of upper-arm PWM_u1 signal, 121 ··· Conduction command period of upper-arm PWM_u2 signal, 122 ··· PWM command pulse width calculation, 123 ··· One-side conduction (Gc off) command, 124 ··· Gs and Gc pattern calculation, 125 ··· PWM_u1 and PWM_u2 signal commands, 126 ··· Narrow on-pulse width, 127 ··· Non-conduction command, 128 ··· Feedback signal, 129 ··· Failure detection signal, 130 ··· Erroneous on operation of dual gate IGBT, 131 ··· Upper-arm feedback_u1 signal, 132 ··· Upper-arm feedback_u2 signal, 133 ··· Normal/failure operation signal, 140 ··· Conduction loss, 141 ··· Turn-off switching loss of existing type of IGBT, 142 ··· Turn-off switching loss of dual gate IGBT, 143 ··· Second gate signal, 152 ··· Gs signal not applied with present invention, 154 ··· Output current waveform of inverter not applied with present invention, 200 ··· Inverter device of second embodiment, 300 ··· Inverter device of third embodiment, 400 ··· Inverter device of fourth embodiment, 500 ··· Inverter device of fifth embodiment, 600 ··· Existing type of inverter device

## Claims

1. An inverter device, comprising:
a first dual gate IGBT connected to an upper arm of each of three phases and a second dual gate IGBT connected to a lower arm of each of the three phases; and
a diode connected in reverse parallel to each of the first and second dual gate IGBTs,
wherein the first and second dual gate IGBTs each have a first gate terminal and a second gate terminal, each of the first and second dual gate IGBTs having a characteristic to shift from a non-conductive state to a conductive state when a voltage equal to or higher than a threshold voltage is applied to at least one of the gate terminals and shift from a conductive state to a non-conductive state when a voltage lower than the threshold voltage is applied to the first and second gate terminals,
wherein the first gate terminal of the first dual gate IGBT is driven by a first gate signal generated by using a first PWM signal having a conduction width modulated based on a voltage command signal for load drive control and the second gate terminal of the first dual gate IGBT is driven by a second gate signal generated by using a third PWM signal, the third PWM signal having a conduction width modulated based on the first PWM signal to be shorter than the conduction width of the first PWM signal and being positioned within a period of the conduction width of the first PWM signal, and
wherein the first gate terminal of the second dual gate IGBT is driven by a third gate signal generated by using a second PWM signal with a polarity inverted with respect to the first PWM signal and the second gate terminal of the second dual gate IGBT is driven by a fourth gate signal generated by using a fourth PWM signal, the fourth PWM signal having a conduction width modulated based on the second PWM signal to be shorter than the conduction width of the second PWM signal and being positioned within a period of the conduction width of the second PWM signal.

2. The inverter device according to claim 1,
wherein the third PWM signal shifts from non-conduction to conduction after elapse of at least 1 µs after timing of shifting of the first PWM signal from non-conduction to conduction and shifts from conduction to non-conduction at least 5 µs before timing of shifting of the first PWM signal from conduction to non-conduction, and
wherein the fourth PWM signal shifts from non-conduction to conduction after elapse of at least 1 µs after timing of shifting of the second PWM signal from non-conduction to conduction and shifts from conduction to non-conduction at least 5 µs before timing of shifting of the second PWM signal from conduction to non-conduction.

3. The inverter device according to one of claims 1 and 2,
wherein the first PWM signal has a conduction width shorter than a non-conduction period width of the second PWM signal, the conduction width being generated to be within a non-conduction period of the second PWM signal, and
wherein the second PWM signal has a conduction width shorter than a non-conduction period width of the first PWM signal, the conduction width being generated to be within a non-conduction period of the first PWM signal.

4. The inverter device according to claim 3,
wherein the first PWM signal shifts from non-conduction to conduction after elapse of at least 2 µs after timing of shifting of the second PWM signal from conduction to non-conduction, and
wherein the second PWM signal shifts from non-conduction to conduction after elapse of at least 2 µs after timing of shifting of the first PWM signal from conduction to non-conduction.

5. The inverter device according to one of claims 1 to 4,
wherein the conduction width of the first PWM signal and a delay time of timing of shifting of the first PWM signal from conduction to non-conduction with respect to timing of shifting of the third PWM signal from conduction to non-conduction are compared and, when the conduction width of the first PWM signal is shorter than the delay time, the third PWM signal maintains non-conduction without shifting to conduction, and
wherein the conduction width of the second PWM signal and a delay time of timing of shifting of the second PWM signal from conduction to non-conduction with respect to timing of shifting of the fourth PWM signal from conduction to non-conduction are compared and, when the conduction width of the second PWM signal is shorter than the delay time, the fourth PWM signal maintains non-conduction without shifting to conduction.

6. The inverter device according to one of claims 1 to 5,
wherein a terminal voltage at the first gate of the first dual gate IGBT is detected, the detected terminal voltage is compared as a first feedback signal with the first PWM signal, and, when the two signals do not agree, a warning signal is outputted, and
wherein a terminal voltage at the first gate of the second dual gate IGBT is detected, the detected terminal voltage is compared as a second feedback signal with the second PWM signal, and, when the two signals do not agree, a warning signal is outputted.

7. The inverter device according to claim 6,
wherein a terminal voltage at the second gate of the first dual gate IGBT is detected, the detected terminal voltage is compared as a third feedback signal with the third PWM signal, and, when the two signals do not agree, a warning signal is outputted, and
wherein a terminal voltage at the second gate of the second dual gate IGBT is detected, the detected terminal voltage is compared as a fourth feedback signal with the fourth PWM signal, and, when the two signals do not agree, a warning signal is outputted.

8. The inverter device according to one of claims 6 and 7, wherein the first through fourth PWM signals are shifted to non-conduction based on the warning signal.

9. The inverter device according to one of claims 1 to 8,
wherein the diode is a Schottky diode using a semiconductor substrate of silicon carbide.

10. The inverter device according to one of claims 1 to 9, comprising:
a PWM control calculation unit that generates the first and second PWM signals;
a first PWM signal conversion unit that receives the first PWM signal and generates the third PWM signal;
a second PWM signal conversion unit that receives the second PWM signal and generates the fourth PWM signal; and
first to fourth gate output circuit units that respectively receive the first to fourth PWM signals and generate the first to fourth gate signals,
wherein a first gate drive circuit is configured including the first PWM signal conversion unit, the first gate output circuit unit, and the third gate output circuit unit, and
wherein a second gate drive circuit is configured including the second PWM signal conversion unit, the second gate output circuit unit, and the fourth gate output circuit unit.

11. The inverter device according to one of claims 1 to 9, comprising:
a PWM control calculation unit that generates the first and second PWM signals;
a first PWM signal conversion unit that receives the first PWM signal and generates the third PWM signal;
a second PWM signal conversion unit that receives the second PWM signal and generates the fourth PWM signal; and
first to fourth gate output circuit units that respectively receive the first to fourth PWM signals and generate the first to fourth gate signals,
wherein a first gate drive circuit is configured including the first gate output circuit unit and the third gate output circuit unit, wherein a second gate drive circuit is configured including the second gate output circuit unit and the fourth gate output circuit unit, and
wherein the first PWM signal conversion unit and the second PWM signal conversion unit are included in the PWM control calculation unit.

12. The inverter device according to one of claims 10 and 11,
wherein the PWM control calculation unit comprises a programmable integrated circuit.

13. An electric railway car mounted with the inverter device according to one of claims 1 to 12.

14. A method of driving an inverter device, the inverter device comprising a first dual gate IGBT connected to an upper arm of each of three phases, a second dual gate IGBT connected to a lower arm of each of the three phases, and a diode connected in reverse parallel to each of the first and second dual gate IGBTs,
wherein: a first gate terminal of the first dual gate IGBT is driven by a first gate signal generated by using a first PWM signal having a conduction width modulated based on a voltage command signal for load drive control; a second gate terminal of the first dual gate IGBT is driven by a second gate signal generated by using a third PWM signal, the third PWM signal having a conduction width modulated based on the first PWM signal to be shorter than the conduction width of the first PWM signal and being positioned within a period of the conduction width of the first PWM signal; and the first dual gate IGBT is caused to shift from a non-conductive state to a conductive state by applying a voltage equal to or higher than a threshold voltage to at least one of the first and second gate terminals and is caused to shift from a conductive state to a non-conductive state by applying a voltage lower than the threshold voltage to the first and second gate terminals, and
wherein: a first gate terminal of the second dual gate IGBT is driven by a third gate signal generated by using a second PWM signal with a polarity inverted with respect to the first PWM signal; a second gate terminal of the second dual gate IGBT is driven by a fourth gate signal generated by using a fourth PWM signal, the fourth PWM signal having a conduction width modulated based on the second PWM signal to be shorter than the conduction width of the second PWM signal and being positioned within a period of the conduction width of the second PWM signal; and the second dual gate IGBT is caused to shift from a non-conductive state to a conductive state by applying a voltage equal to or higher than a threshold voltage to at least one of the first and second gate terminals and is caused to shift from a conductive state to a non-conductive state by applying a voltage lower than the threshold voltage to the first and second gate terminals.

15. The method of driving an inverter device according to claim 14, wherein the third PWM signal is caused to shift from non-conduction to conduction after elapse of at least 1 µs after timing of shifting of the first PWM signal from non-conduction to conduction and is caused to shift from conduction to non-conduction at least 5 µs before timing of shifting of the first PWM signal from conduction to non-conduction, and
wherein the fourth PWM signal is caused to shift from non-conduction to conduction after elapse of at least 1 µs after timing of shifting of the second PWM signal from non-conduction to conduction and is caused to shift from conduction to non-conduction at least 5 µs before timing of shifting of the second PWM signal from conduction to non-conduction.

16. The method of driving an inverter device according to one of claims 14 and 15,
wherein the first PWM signal is generated to have a conduction width shorter than a non-conduction period width of the second PWM signal and such that the conduction width is positioned within a non-conduction period of the second PWM signal, and
wherein the second PWM signal is generated to have a conduction width shorter than a non-conduction period width of the first PWM signal and such that the conduction width is positioned within a non-conduction period of the first PWM signal.

17. The method of driving an inverter device according to claim 16,
wherein the first PWM signal is caused to shift from non-conduction to conduction after elapse of at least 2 µs after timing of shifting of the second PWM signal from conduction to non-conduction, and
wherein the second PWM signal is caused to shift from non-conduction to conduction after elapse of at least 2 µs after timing of shifting of the first PWM signal from conduction to non-conduction.

18. The method of driving an inverter device according to one of claims 14 to 17,
wherein the conduction width of the first PWM signal and a delay time of timing of shifting of the first PWM signal from conduction to non-conduction with respect to timing of shifting of the third PWM signal from conduction to non-conduction are compared and, when the conduction width of the first PWM signal is shorter than the delay time, the third PWM signal is caused to maintain non-conduction without shifting to conduction, and
wherein the conduction width of the second PWM signal and a delay time of timing of shifting of the second PWM signal from conduction to non-conduction with respect to timing of shifting of the fourth PWM signal from conduction to non-conduction are compared and, when the conduction width of the second PWM signal is shorter than the delay time, the fourth PWM signal is caused to maintain non-conduction without shifting to conduction.

19. The method of driving an inverter device according to one of claims 14 to 18,
wherein a terminal voltage at the first gate of the first dual gate IGBT is detected, the detected terminal voltage is compared as a first feedback signal with the first PWM signal, and, when the two signals do not agree, a warning signal is outputted, and
wherein a terminal voltage at the first gate of the second dual gate IGBT is detected, the detected terminal voltage is compared as a second feedback signal with the second PWM signal, and, when the two signals do not agree, a warning signal is outputted.

20. The method of driving an inverter device according to claim 19,
wherein a terminal voltage at the second gate of the first dual gate IGBT is detected, the detected terminal voltage is compared as a third feedback signal with the third PWM signal, and, when the two signals do not agree, a warning signal is outputted, and
wherein a terminal voltage at the second gate of the second dual gate IGBT is detected, the detected terminal voltage is compared as a fourth feedback signal with the fourth PWM signal, and, when the two signals do not agree, a warning signal is outputted.
